# EUROPÄISCHE PATENTSCHRIFT

(11) **EP 0 901 992 B1**
(45) Veröffentlichungstag und Bekanntmachung des Hinweises auf die Patenterteilung: **02.05.2003**
(21) Anmeldenummer: 98112829.1
(22) Anmeldetag: 10.07.1998
(51) Int. Cl.: C03C 27/04, C04B 37/02

(54) **Lötverfahren für optische Materialen an Metallfassungen und gefasste Baugruppen**
Method of soldering optical materials to metallic frames and framed units
Procédé de soudage de matériaux optiques aux montures metalliques et structures modulaires

(30) Priorität: 18.08.1997 DE 19735760
(43) Veröffentlichungstag der Anmeldung: 17.03.1999
(73) Patentinhaber: Carl Zeiss SMT AG, 73447 Oberkochen (DE)
(72) Erfinder: Holderer, Hubert, 89551 Königsbronn (DE); Deyhle, Johannes, 89551 Königsbronn (DE); Dietenmeier, Ulrich, 73466 Lauchheim (DE)
(74) Vertreter: Müller-Rissmann, Werner Albrecht, Dr.

(56) Entgegenhaltungen:
- DE-A- 3 827 318
- DE-B- 1 533 542
- US-A- 4 210 389
- US-A- 4 321 617
- US-A- 4 615 951
- US-A- 4 649 085
- US-A- 4 726 507
- US-A- 5 082 161
- DATABASE WPI Section Ch, Week 198334 Derwent Publications Ltd., London, GB; Class L03, AN 1983-744552 XP002118852 & JP 58 120578 A (MATSUSHITA ELEC IND CO LTD), 18. Juli 1983 (1983-07-18)

## Beschreibung

Die Erfindung betrifft ein Verfahren nach dem Oberbegriff des Anspruchs 1 und eine Baugruppe nach dem Oberbegriff des Anspruchs 8.

Aus der DE 38 27 318 A ist das Verlöten von Quarzglas u.a. mit einer Nickel-Eisen-Legierung mit einem Zwischenring aus Aluminium, beschichtet mit Zinn oder Zink und Gold oder Silber bekannt. Die Teile werden im Ofen bei ca. 600° C verlötet. Das Augenmerk dieser Patentanmeldung ist auf die Dichtigkeit der Verbindung gerichtet.

JP 1/215 745 A (Derwent WPI Abstract) beschreibt das Ofenlöten von Quarzglas mit Metall mit einem Lot aus Indium, Zinn, Siliziumkarbid und Kohlenstoff bei Temperaturen oberhalb 100° C und unter Druck. Beschichtungen sind nicht vorgesehen. Spannungen werden durch die Lotschicht abgebaut.

Laut JP 58/120 578 A (Derwent WPI Abstract) wird Quarz, Borosilikatglas oder andere Materialien vorzugsweise durch Einbrennen einer Paste mit einem Film aus Edelmetall beschichtet. Ein Metallteil wird mit Titan oder Zirkonium beschichtet und anschließend mit Silberlot oder Silber-Kupfer-Lot. Beide Teile werden zusammengesetzt und im Vakuum oder unter Schutzgas erhitzt. Das verwendete Hartlot bedingt dabei hohe Temperaturen. Die Teile sind vorzugsweise komplex geformt und porös oder schaumig. Optische Elemente sind nicht angesprochen.

Gesucht ist eine Technik, mit der optische Elemente auf Fassungen gelötet werden können. Dazu müssen niedrige Prozeßtemperaturen unter etwa 200°C bis unter 150°C eingehalten werden, um dünne optische Schichten, aber auch den Linsenwerkstoff an sich, z.B. optisches Glas, Quarzglas, Kalziumfluorid, oder andere Fluoride, zu schützen. Zugleich sind thermische und andere Spannungen einschließlich Druckbeanspruchungen während des Lötverfahrens wie davor und danach minimal zu halten, da sie für die Beständigkeit des Werkstoffs und die optische Funktion eine beträchtliche Gefahr darstellen. Zugleich muß eine ausreichende Festigkeit der Verbindung mit einer Zugscherfestigkeit oberhalb von etwa 10 N/mm² erreicht werden.

Gelöst wird diese Aufgabe durch ein Verfahren nach Anspruch 1 und eine Baugruppe nach Anspruch 8. Vorteilhafte Ausführungsformen sind Gegenstand der Unteransprüche 2 bis 7 und 9 bis 15.

Das Verlöten mit gemeinsamer Temperaturführung aller Partner hält thermische Spannungen minimal, was durch niedrigschmelzendes Lot unterstützt wird.

Die ersten Beschichtungen beider Teile sorgen für gute Festigkeit, die jeweiligen Antioxidationsschichten ermöglichen einfache Handhabung unter Vermeidung von Flußmitteln, die vor allem für optische Flächen von Linsen und dergleichen erhebliche Risiken darstellen würden.

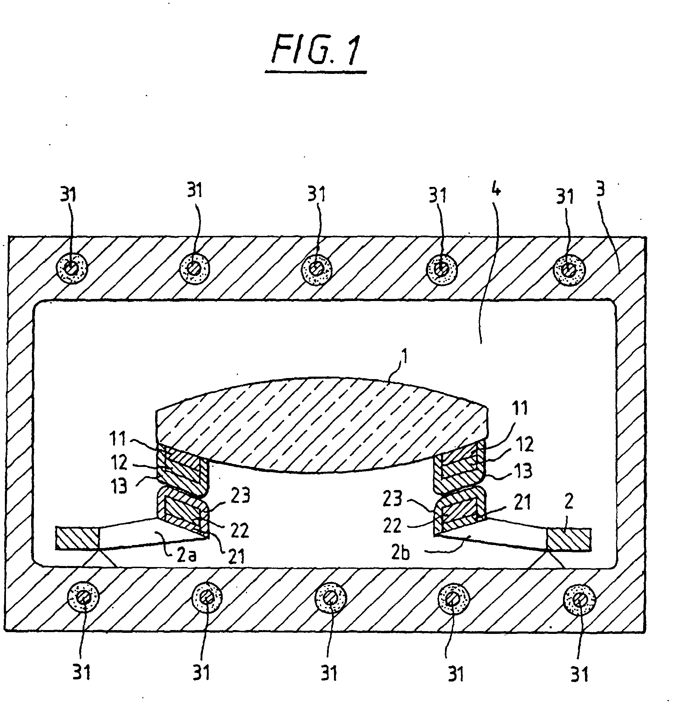

Näher erläutert wird die Erfindung beispielhaft anhand der Zeichnung, deren
- Figur 1: Linse und Fassung mit erfindungsgemäßen Schichten im Ofen zeigt, alles schematisch.

Das Teil 1 aus transparentem Werkstoff ist im gezeigten Beispiel eine Linse, speziell eine hochgenaue UV-Linse aus Quarzglas oder Kalziumfluorid, die Teil einer Projektionsbelichtungsanlage für die Mikrolithographie ist. Hinsichtlich Störungen wie Formveränderungen oder Spannungsdoppelbrechung einzelner Linsen ist ein solches System äußerst empfindlich. Besonders der Werkstoff Kalziumfluorid ist durch seine Kristallstruktur zudem gegen Temperaturdifferenzen im Werkstück bruchempfindlich. Hochwertige Antireflexschichten auf der Linse (hier nicht dargestellt) dürfen ebenfalls nicht thermisch strapaziert werden, um Veränderungen zu vermeiden.

Die Fassung 2 ist diesen Erfordernissen angepaßt. Die Linse 1 ist in einer Dünnschicht-Beschichtungsanlage mit einer Haftschicht 11, einer lötfähigen Diffusionssperrschicht 12 und einer ersten Oxidationsschutzschicht 13 versehen. Diese Beschichtung erfolgt in einer Vakuum-Beschichtungsanlage mit einer Maske, welche die optisch genutzten Flächen der Linse 1 zuverlässig abdeckt. Das Sputtern hat sich als besonders geeignete Dünnschichttechnik herausgestellt, da bei niedrigen Temperaturen gut haftende Schichten erzeugt werden.

Das als Fassung dienende Teil 2 wird im voraus mit Lot 22 versehen. Um niedrigschmelzendes Lot mit einem Metallteil 2 aus Edelstahl verbinden zu können, ist jedoch eine Benetzungshilfsschicht zuerst auf das Metallteil 2 aufgebracht.

Auch die darauf folgend aufgetragene Lotschicht 22 wird vorzugsweise mit einer Oxidationsschutzschicht 23 überzogen. Damit kann das beschichtete Teil 2 ohne Beeinträchtigung des Lots gehandhabt werden und erhitzt werden.

Da die Lotschicht 22 eine Dicke von ca. 100 µm hat, sind Dünnschichttechniken wie das Sputtern für ihre Herstellung nicht praktikabel. Alle drei Schichten 21 bis 23 werden daher vorzugsweise galvanisch aufgetragen. Die gleiche Beschichtungstechnologie für alle drei Schichten hat den großen Vorteil, daß sie unmittelbar nacheinander, ohne großen Handlingaufwand und ohne Lagerzeit, in der Oxidation auftreten würde, ausgeführt werden kann.

Die beschichtete Linse 1 und die beschichtete Fassung 2 werden aufeinander positioniert - dazu werden nach Bedarf Justier- und Haltevorrichtungen verwendet - und in einen Ofen 3 eingebracht. Dessen Innenraum 4 wird vorzugsweise mit N₂ oder einem anderen Schutzgas geflutet. Mittels (elektrischen) Heizstäben 31 wird der Ofen 3 beheizt, bis die Schmelztemperatur des Lotes 22 erreicht wird. Dieses bildet dann mit den beiden Oxidationsschutzschichten 23 und 13 und vorwiegend mit der Diffusionssperrschicht 12 Legierungen und benetzt flächig das transparente Teil 1 (die Linse) im Verbindungsbereich.

Für ein Beispiel gibt Tabelle 1 die bevorzugten Schichtmaterialien und -dicken.

**Tabelle 1**

| | | Material | Dicke [µm] |
|---|---|---|---|
| 1 | Linse | Ca F₂ | |
| 11 | Haftschicht | Cr | 0,5 |
| 12 | Diffusionssperrschicht | Ni | 5 |
| 13 | 1. Oxidationsschutzschicht | Au | 0,1 |
| 23 | 2. Oxidationsschutzschicht | Au | 0,1 |
| 22 | Lot | SnPb | 100 |
| 21 | Benetzungshilfsschicht | Ni | 5 |
| 2 | Fassung | Edelstahl | |

Die Schmelztemperatur beträgt dabei 183° C. Die Erwärmung erfolgt in 15 min, die Abkühlung auf Zimmertemperatur in 30 min. Die Zugscherfestigkeit der Verbindung erreicht 15 MPa.

Für Quarzglas als transparentes Teil sind die gleichen Schichten geeignet wie für Kalziumfluorid, ebenso für Reinaluminium und Titan als Fassungswerkstoffe. Messing oder Kupfer als Fassungswerkstoffe benötigen keine Benetzungshilfsschicht 21.

Quarzglas statt Kalziumfluorid verkraftet auch größere thermische Beanspruchungen, so daß hiermit auch die Erhitzung ohne Ofen, z.B. induktiv, durch eine Heizplatte, einen Infrarotstrahler usw.erfolgen kann.

Als Lote kommen auch andere Legierungen mit niedrigem Schmelzpunkt in Frage, z.B. 52In48Sn mit 118° C und 80In15Pb5Ag mit 149° C Schmelztemperatur.

Als Oxidationsschutzschicht 13, 23 kommen alle zu dem Lot 22 bzw. zur Diffusionssperrschicht 12 bekannten Passivierungsschichten in Frage.

Die Schichtdicken können natürlich variiert werden. Besonders die Dicke der Lotschicht 22 kann der Toleranz der Fügeflächen des transparenten Teils 1 und des Metallteils 2 angepaßt werden.

## Patentansprüche

1. Verfahren zum Verbinden eines Teiles (1) aus Quarzglas oder Kalziumfluorid mit einem Metallteil (2), **dadurch gekennzeichnet, daß**
- auf das Teil (1) im Fügebereich eine Haftschicht (11) aus Cr, A1 oder TiW und eine lötfähige Diffusionssperre (12) in einer Vakuum-Beschichtungsanlage mit einer Maske, welche die optisch genutzten Flächen des Teiles (1) abdeckt, aufgebracht werden,
- das Metallteil (2) mit einer Lotschicht (22) versehen wird,
- das Teil (1) und das Metallteil (2) aufeinander positioniert werden und dann
- gemeinsam auf Schmelztemperatur der Lotschicht (22) gebracht werden, wobei die Schmelztemperatur unter 200°C, vorzugsweise unter 120°C liegt.

2. Verfahren nach Anspruch 1, **dadurch gekennzeichnet, daß** die Diffusionssperre (12) und/oder die Lotschicht (22) mit einer Oxidationsschutzschicht (13, 23) beschichtet werden.

3. Verfahren nach mindestens einem der Ansprüche 1-2, **dadurch gekennzeichnet, daß** die Lotschicht (22) galvanisch aufgebracht wird.

4. Verfahren nach mindestens einem der Ansprüche 1-3, **dadurch gekennzeichnet, daß** das Metallteil (2) mit einer Benetzungshilfsschicht (21), der Lotschicht (22) und einer Oxidationsschutzschicht (23) versehen wird, vorzugsweise jeweils durch galvanische Abscheidung.

5. Verfahren nach mindestens einem der Ansprüche 1-4, **dadurch gekennzeichnet, daß** das Teil (1) aus transparentem Werkstoff in Dünnschichttechnik, insbesondere durch Sputtern, beschichtet wird.

6. Verfahren nach mindestens einem der Ansprüche 1-5, **dadurch gekennzeichnet, daß** das Erhitzen auf Schmelztemperatur in einem Ofen (3) erfolgt.

7. Verfahren nach mindestens einem der Ansprüche 1-6, **dadurch gekennzeichnet, daß** Teil (1) und Metallteil (2) auch gemeinsam auf Raumtemperatur abgekühlt werden, insbesondere in einem Ofen (3).

8. Baugruppe, bestehend aus einem Teil (1) aus transparentem Werkstoff, nämlich Quarzglas oder Kalziumfluorid, und einem damit verlöteten Metallteil (2), **dadurch gekennzeichnet, daß** im Bereich einer Lötverbindung folgender Schichtaufbau vorliegt:
- transparenter Werkstoff des einen Teils (1)
- gesputterte Haftschicht (11) aus Cr, A1, oder TiW
- gesputterte Diffusionssperrschicht (12) aus Nickel
- vorzugsweise erste Oxidationsschutzschicht (13)
- vorzugsweise zweite Oxidationsschutzschicht (23)
- Lot (22) mit einer Schmelztemperatur unter 200°C, vorzugsweise unter 120°C
- bedarfsweise Benetzungshilfsschicht (21)
- Metall des Metallteils (2)
jeweils mit Übergängen zwischen den Schichten (11-23), insbesondere in für das Löten typischer Weise und gegebenenfalls mit Eindiffusion der zwei Oxidationsschutzschichten (13, 23) in das Lot (22) wobei das Lot (22) galvanisch auf die Benetzungshilfsschicht (21) oder das Metall des Metallteils (2) abgeschieden ist.

9. Baugruppe nach Anspruch 8, **dadurch gekennzeichnet, daß** die erste Oxidationsschutzschicht (13) aus Gold besteht.

10. Baugruppe nach Anspruch 8 oder 9, **dadurch gekennzeichnet, daß** die zweite Oxidationsschutzschicht (23) aus Gold besteht.

11. Baugruppe nach mindestens einem der Ansprüche 8-10, **dadurch gekennzeichnet, daß** das Lot (22) aus einer Zinn- oder Indiumlegierung besteht.

12. Baugruppe nach mindestens einem der Ansprüche 8-11, **dadurch gekennzeichnet, daß** die Benetzungshilfsschicht (21) aus Ni oder Cu besteht.

13. Baugruppe nach mindestens einen der Ansprüche 8-12, **dadurch gekennzeichnet, daß** das Metall des Metallteils (2) aus Stahl oder einer Eisen-Nickel-Legierung besteht.

14. Baugruppe nach mindestens einem der Ansprüche 8-13, **dadurch gekennzeichnet, daß** das eine Teil (1) ein optisches Bauelement, z.B. eine optische Linse, ein Spiegel oder ein Prisma ist.

15. Baugruppe nach Anspruch 14, **dadurch gekennzeichnet, daß** das Metallteil (2) eine Fassung ist.

## Claims

1. Process for joining a part (1) made from quartz glass or calcium fluoride to a metal part (2), **characterized in that**
- a bonding layer (11) of Cr, Al or TiW and a diffusion barrier (12), which can be soldered, are applied to the part (1) in a vacuum-coating installation with a mask which covers the optically utilized areas of the part (1),
- the metal part (2) is provided with a layer of solder (22),
- the part (1) and the metal part (2) are positioned one on top of the other, and then
- are jointly heated to the melting point of the layer of solder (22), the melting point being below 200°C, preferably below 120°C.

2. Process according to Claim 1, **characterized in that** the diffusion barrier (12) and/or the layer of solder (22) are coated with an oxidation-resistant layer (13, 23).

3. Process according to at least one of Claims 1-2, **characterized in that** the layer of solder (22) is applied by electrodeposition.

4. Process according to at least one of Claims 1-3, **characterized in that** the metal part (2) is provided with a wetting auxiliary layer (21), the layer of solder (22) and an oxidation-resistant layer (23), preferably in each case by means of electrodeposition.

5. Process according to at least one of Claims 1-4, **characterized in that** the part (1) made from transparent material is coated using thin-film technology, in particular by sputtering.

6. Process according to at least one of Claims 1-5, **characterized in that** the heating to the melting point takes place in a furnace (3).

7. Process according to at least one of Claims 1-6 **characterized in that** part (1) and metal part (2) are also jointly cooled to room temperature, in particular in a furnace (3).

8. Assembly comprising a part (1) made from transparent material, namely quartz glass or calcium fluoride, and a metal part (2) which is soldered to it, **characterized in that** the following layer structure is present in the region of a soldered joint:
- transparent material of one part (1)
- sputtered bonding layer (11) of Cr, Al or TiW
- sputtered diffusion barrier layer (12) of nickel
- preferably, first oxidation-resistant layer (13)
- Preferably, second oxidation-resistant layer (23)
- solder (22) with a melting point of less than 200°C, preferably less than 120°C
- if necessary, wetting auxiliary layer (21)
- metal of the metal part (2)
in each case with transitions between the layers (11-23), in particular in a manner which is typical for soldering and if appropriate with diffusion of the two oxidation-resistant layers (13, 23) into the solder (22), the solder (22) being applied to the wetting auxiliary layer (21) or the metal of the metal part (2) by electrodeposition.

9. Assembly according to Claim 8, **characterized in that** the first oxidation-resistant layer (13) consists of gold.

10. Assembly according to Claim 8 or 9, **characterized in that** the second oxidation-resistant layer (23) consists of gold.

11. Assembly according to at least one of Claims 8-10, **characterized in that** the solder (22) consists of a tin or indium alloy.

12. Assembly according to at least one of Claims 8-11, **characterized in that** the wetting auxiliary layer (21) consists of Ni or Cu.

13. Assembly according to at least one of Claims 8-12, **characterized in that** the metal of the metal part (2) consists of steel or an iron-nickel alloy.

14. Assembly according to at least one of Claims 8-13, **characterized in that** one part (1) is an optical component, e.g. an optical lens, a mirror or a prism.

15. Assembly according to Claim 14, **characterized in that** the metal part (2) is a mount.

## Revendications

1. Procédé pour l'assemblage d'une pièce (1) à base de verre quartzeux ou de fluorure de calcium avec une pièce métallique (2), **caractérisé en ce que**
- on applique sur la partie (1) dans la zone du joint, une couche adhésive (11) à base de Cr, Al ou TiW et une barrière de diffusion (12) apte au brasage, dans une unité d'enduction sous vide, avec un masque qui recouvre les surfaces de la pièce (1) utilisées à des fins optiques
- on munit d'une couche de brasage (22) la pièce métallique (2),
- on place l'une sur l'autre la pièce (1) et la pièce métallique (2) et ensuite
- on les porte ensemble à la température de fusion de la couche de brasage (22), la température de fusion étant inférieure à 200°C, de préférence inférieure à 120°C.

2. Procédé selon la revendication 1, **caractérisé en ce que** la barrière de diffusion (12) et/ou la couche de brasage (22) sont revêtues d'une couche de protection contre l'oxydation (13, 23).

3. Procédé selon au moins l'une des revendications 1-2, **caractérisé en ce que** la couche de brasage (22) est appliquée par galvanoplastie.

4. Procédé selon au moins l'une des revendications 1-3, **caractérisé en ce que** la pièce métallique (2) est munie d'une couche auxiliaire de mouillage (21), de la couche de brasage (22) et d'une couche de protection contre l'oxydation (23), de préférence chacune par dépôt par galvanoplastie.

5. Procédé selon au moins l'une des revendications 1-4, **caractérisé en ce que** la pièce (1) à base d'un matériau transparent est revêtue par la technique de couche mince, en particulier par pulvérisation cathodique.

6. Procédé selon au moins l'une des revendications 1-5, **caractérisé en ce que** le chauffage jusqu'à la température de fusion s'effectue dans un four (3).

7. Procédé selon au moins l'une des revendications 1-6, **caractérisé en ce que** la pièce (1) et la pièce métallique (2) sont refroidies ensemble jusqu'à la température ambiante, en particulier dans un four (3).

8. Ensemble constitué d'une pièce (1) à base d'un matériau transparent, à savoir de verre quartzeux ou de fluorure de calcium, et d'une pièce métallique (2) assemblée par brasage avec celle-ci, **caractérisé en ce que** la structure de couches suivante est présente dans la zone d'un assemblage par brasage :
- matériau transparent de la pièce (1)
- couche adhésive (11) déposée par pulvérisation cathodique, à base de Cr, Al ou TiW
- couche barrière de diffusion (12) à base de nickel
- de préférence première couche de protection contre l'oxydation (13)
- de préférence seconde couche de protection contre l'oxydation (23)
- brasure (22) ayant une température de fusion inférieure à 200°C, de préférence inférieure à 120°C
- au besoin couche auxiliaire de mouillage (21)
- métal de la pièce métallique (2)
chaque fois avec jonctions entre les couches (11-23), en particulier de la façon caractéristique pour le brasage et éventuellement avec pénétration par diffusion des deux couches de protection contre l'oxydation (13, 23) dans la brasure (22), la brasure (22) étant déposée par galvanoplastie sur la couche auxiliaire de mouillage (21) ou sur le métal de la pièce métallique (2).

9. Ensemble selon la revendication 8, **caractérisé en ce que** la première couche de protection contre l'oxydation (13) est constituée d'or.

10. Ensemble selon la revendication 8 ou 9, **caractérisé en ce que** la seconde couche de protection contre l'oxydation (23) est constituée d'or.

11. Ensemble selon au moins l'une des revendications 8-10, **caractérisé en ce que** la brasure (22) consiste en un alliage d'étain ou d'indium.

12. Ensemble selon au moins l'une des revendications 8-11, **caractérisé en ce que** la couche auxiliaire de mouillage (21) consiste en Ni ou Cu.

13. Ensemble selon au moins l'une des revendications 8-12, **caractérisé en ce que** le métal de la pièce métallique (2) consiste en acier ou en un alliage de fer-nickel.

14. Ensemble selon au moins l'une des revendications 8-13, **caractérisé en ce que** la pièce (1) est un composant optique, par exemple une lentille optique, un miroir ou un prisme.

15. Ensemble selon la revendication 14, **caractérisé en ce que** la pièce métallique (2) est une monture.
